# EUROPÄISCHE PATENTSCHRIFT

(11) **EP 1 488 549 B1**
(45) Veröffentlichungstag und Bekanntmachung des Hinweises auf die Patenterteilung: **14.12.2005**
(21) Anmeldenummer: 03744765.3
(22) Anmeldetag: 24.03.2003
(51) Int. Cl.: H04B 10/158

(54) **OPTISCHER FASEREMPFAENGER MIT ERHOEHTER BANDBREITE**
OPTICAL FIBER RECEIVER HAVING AN INCREASED BANDWIDTH
RECEPTEUR A FIBRES OPTIQUES PRESENTANT UNE MEILLEURE BANDE PASSANTE

(30) Priorität: 22.03.2002 DE 10213045
(43) Veröffentlichungstag der Anmeldung: 22.12.2004
(73) Patentinhaber: Melexis GmbH, 99097 Erfurt (DE)
(72) Erfinder: ZIMMERMANN, Horst, A-3032 Eichgraben (AT); FOERTSCH, Michael, A-1140 Wien (AT); PLESS, Holger, 99100 Bienstädt (DE)
(74) Vertreter: Leonhard, Frank Reimund
(86) Internationale Anmeldenummer: PCT/DE2003/000969
(87) Internationale Veröffentlichungsnummer: WO 2003/081813

(56) Entgegenhaltungen:
- US-A1- 2002 003 649
- ZIMMERMANN H: "Monolithic bipolar-, CMOS-, and BiCMOS-receiver OEICs" 1996 INTERNATIONAL SEMICONDUCTOR CONFERENCE. SINAIA, ROMANIA, OCT. 9 - 12, 1996, INTERNATIONAL SEMICONDUCTOR CONFERENCE, NEW YORK, IEEE, US, Bd. 2 CONF. 19, 9. Oktober 1996 (1996-10-09), Seiten 31-40, XP010200521 ISBN: 0-7803-3223-7
- PATENT ABSTRACTS OF JAPAN vol. 1998, no. 06, 30. April 1998 (1998-04-30) & JP 10 038683 A (NIKON CORP), 13. Februar 1998 (1998-02-13)
- PATENT ABSTRACTS OF JAPAN vol. 1998, no. 11, 30. September 1998 (1998-09-30) & JP 10 164624 A (SONY CORP), 19. Juni 1998 (1998-06-19)

## Beschreibung

Die Erfindung betrifft einen (monolithisch) integrierten optischen Faserempfänger mit einer erhöhten Empfindlichkeit und vergrößerter Bandbreite.

Bekannte optische Faser-Empfänger bestehen im wesentlichen aus einer Fotodiode sowie einem Transimpedanzverstärker, welcher den Fotodiodenstrom in eine proportionale Spannung umsetzt, vgl. bspw. **DE 32 33 146** (AT&T Technologies), US 2002/0003649 oder **DE 33 38 024** (SEL AG). Es kann außerdem eine Entscheider-Schaltung folgen, welche zu entscheiden hat, ob der empfangene Lichtpegel einer logischen Null oder Eins entspricht Bei Lichtleitfasern mit größeren Durchmessern ist der zu empfangende Lichtfleck entsprechend groß. Bei Verwendung von z.B. Plastikfasem kann der zu empfangende Lichtfleck verhältnismäßig sehr groß sein (bis zu einem Millimeter Durchmesser). Um den ankommenden Lichtstrom voll auszunutzen zu können, wird die empfangende Fotodiode in ihrer fotoempfindlichen Fläche entsprechend angepaßt. Mit der steigenden Empfängerfläche wächst jedoch die Sperrschichtkapazität einer Fotodiode, was eine Verschlechterung sowohl ihrer Geschwindigkeit als auch des Rauschverhaltens des nachgeschalteten Transimpedanzverstärkers mit sich bringt.

**Ein technisches Problem** der Erfindung ist es, eine verhältnismäßig große lichtempfindliche Empfängerfläche für schnelle optische Signale zur Verfügung zu stellen und dennoch Bandbreite und Empfindlichkeit des optischen Empfängers zu erhöhen.

Die Aufgabe wird erfindungsgemäß dadurch gelöst, daß eine der Größe des Lichtflecks angepaßte optische Empfängerdiode unterteilt wird, wobei jeder einzelnen Teil-Fotodiode ein eigener Transimpedanzverstärker folgt. Die Ausgangssignale der einzelnen (separaten) Transimpedanzverstärker werden in einem Summenverstärker addiert.

Da die Teil-Fotodioden eine geringere Sperrschichtkapazität haben als eine ihrer Summenfläche entsprechende größere Gesamtdiode, besitzen die einzelnen Transimpedanzverstärker eine größere Bandbreite und ein besseres Rauschverhalten. Diese Eigenschaften werden vom Summenverstärker nur noch unwesentlich beeinflußt.

Das Teilungsprinzip des optischen Empfängers kann auch in Bipolar- und BICMOS-OEICs ausgeführt werden, die aufgrund der höheren Verstärkung noch höhere Datenraten als 622Mbit/s bei einem effektiven Durchmesser von bis zu 1 mm bei einer Fotodiode erreichen können.

Diese hohen Datenraten können erstmals mit Hilfe des Fotodioden-Teilungsprinzips zusammen mit einem effektiven Fotodiodendurchmesser von bis zu 1mm erreicht werden. Somit kann eine optoelektronische integrierte Schaltung (OEIC) für eine Plastikfaser mit im Wesentlichen 1mm Durchmesser eine Datenrate von über 500Mbit/s erreichen.

Eine weitere Anwendungsmöglichkeit liegt in optischen Empfängern für Glasfasern oder Plastikfasern, die eine hohe Justiertoleranz von optischen Steckverbindungen zulassen, bzw. keine Justierung erfordern.

Die Erfindung wird anhand von Ausführungs**beispielen** näher erläutert. Alle dargestellten Elemente sollen als auf einem Chip integriert in CMOS-Technologie hergestellt verstanden werden, soweit nicht anderweitig erläutert.

**Figur 1** ist eine Draufsicht auf eine Fotodiode eines optischen Faser-Empfängers bekannter Art (schematisch).

**Figur 2** ist eine Schaltung der Fotodiode mit einem Transimpedanzverstärker 29.

**Figur 3** ist eine Draufsicht auf eine Fotodiode eines Beispiels des erfindungsgemäßen optischen Faser-Empfängers (schematisch).

**Figur 4** ist eine erfindungsgemäße Schaltung mit Teil-Fotodioden und mit mehreren Transimpedanzverstärkem und dem Summenverstärker.

**Figur 5** ist ein vertikaler Schnitt durch die PIN-Fotodiode gemäß Figur 3 (schematisch).

**Figur 6** ist ein Diagramm der Eingangsrauschstromdichte aufgetragen über der Frequenz.

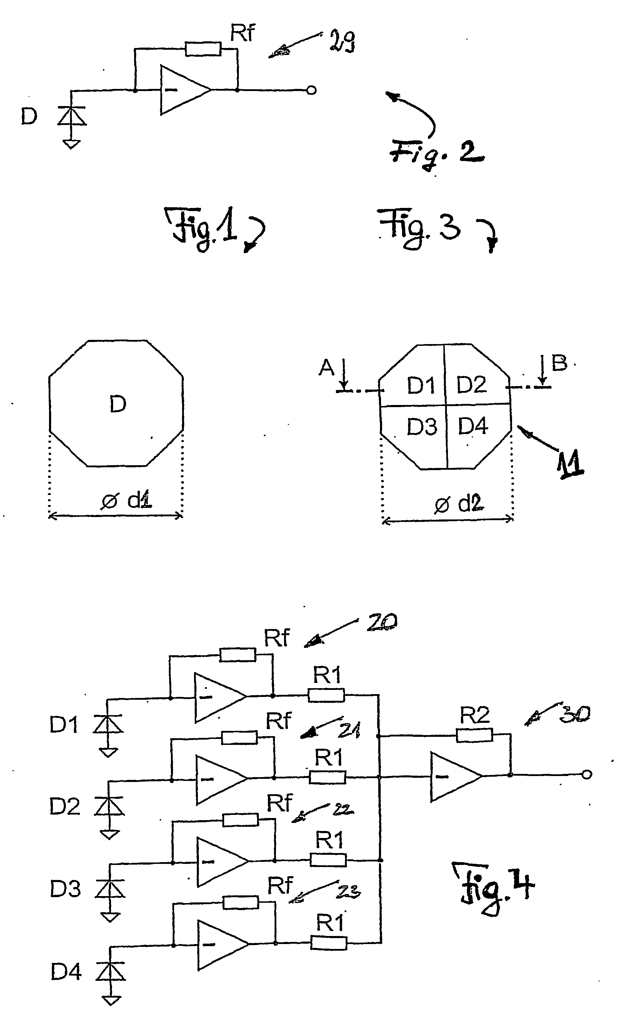

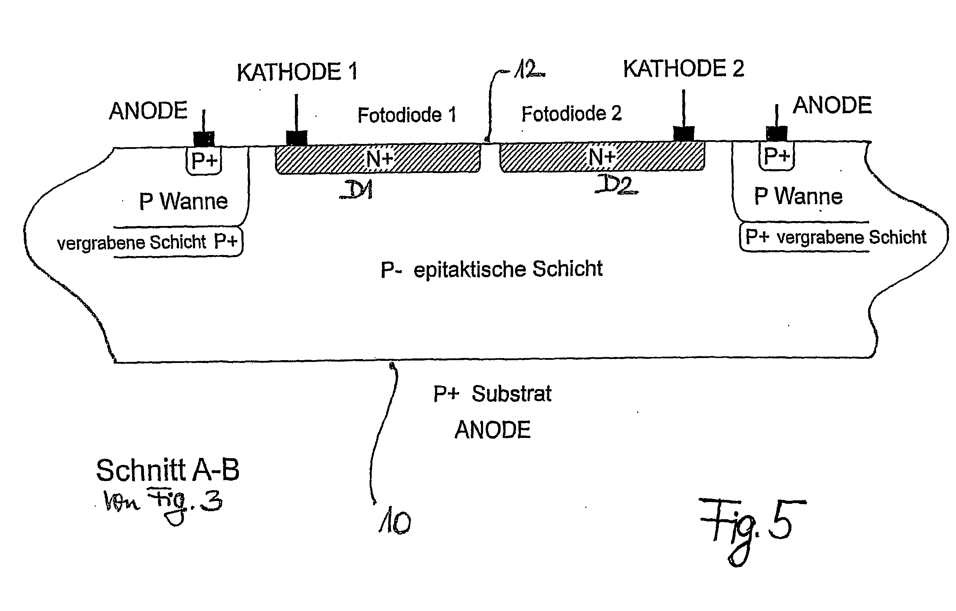

Die ganzflächige Fotodiode D in **Figur 1,** mit einer 0,6µm-CMOS-Technologie hergestellt, hat einen Durchmesser "d1" von 400µm und eine Sperrschichtkapazität von etwa 1,6pF. Die vier Teil-Fotodioden D1, D2, D3, D4 in **Figur 3** haben eine Sperrschichtkapazität von (je) 400fF. Ein elektrischer Kontakt 10 der Fotodioden an der Substratrückseite (siehe **Figur 5** mit Schnitt A-B aus Figur 3) reduziert den Serienwiderstand der PIN-Dioden erheblich.

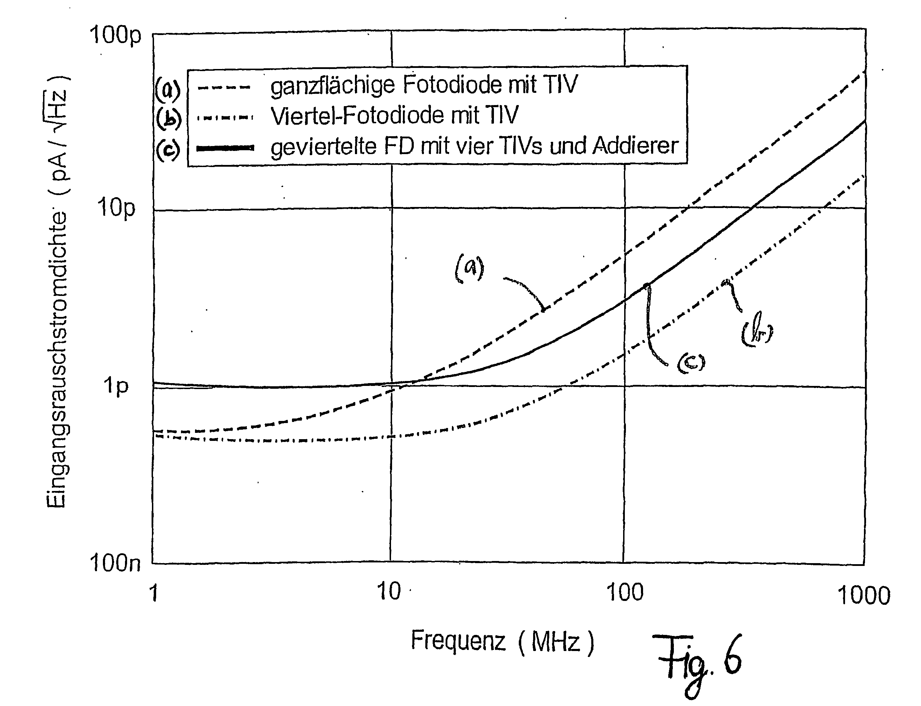

Die Transimpedanzverstärker 20 bis 23 gemäß **Figur 4** haben eine Transimpedanz von 70kOhm und der Summenverstärker 30 eine Verstärkung von 2,5. Die Bandbreite des Transimpedanzverstärkers 29 mit ganzflächiger Fotodiode D beträgt nach Figur 1 und 2 151 MHz, die des Gesamtsystems mit viergeteilter Fotodiode 11 nach Figur 3 und 4 bei gleicher Empfängerfläche 402MHz.

Die Transimpedanz des Gesamtsystems mit viergeteilter Fotodiode nach Figur 4 beträgt 164kOhm.

Die Verschaltung der einzelnen Fotodioden D1 bis D4 in elektrischer Hinsicht ist aus Figur 4 ersichtlich. Jeweils ein eigener Verstärker 20 bis 23 ist jeweils einer Teildiode zugeordnet und nimmt deren elektrisches Ausgangssignal auf. Über eine Beschaltung als Strom-Spannungs-Wandler mit dem Rückkoppel-Widerstand Rf ist jeder der einzelnen Transimpedanz-Verstärker für eine jeweilige Teildiode zuständig. Die Ausgangssignale sind nicht gesondert bezeichnet, liegen aber an dem Eingangswiderstand R1 der Summenschaltung 30 an, die über ihren Rückkoppelwiderstand R2 den Verstärkungsfaktor der Summenschaltung bestimmt. Dieser ist gemäß obiger Darstellung zu 2,5 gewählt.

Der einzelne Aufbau der Dioden gemäß Figur 3 ist aus der Schnittansicht der Figur 5 ersichtlich. Die dort durch den Schnitt A-B ersichtlichen beiden geschnittenen Fotodioden D1 und D2 als Fotodiode 1 und Fotodiode 2 sind innen durch einen schmalen Streifen 12 beabstandet hinsichtlich des N+ Gebietes. Dieses Kathodengebiet ist für jede Fotodiode eigenständig und an den jeweiligen Verstärker gemäß Figur 4 angeschlossen. In dem P+ Gebiet über der P-Wanne und der vergrabenen Schicht P+ in der epitaktischen Schicht und auf beiden Seiten der N+ Schicht jeder Fotodiode D1 und D2 ist der jeweilige Anodenanschluß einer Teildiode. Die Anode kann mit Masse verbunden werden.

Eine weitere Anode 10 auf der Substratrückseite kann den Serienwiderstand der Dioden erheblich reduzieren.

Figur 5 ist nur ein Ausschnitt aus einer integrierten Schaltung, die sich links und rechts weitergehend erstrecken kann, insbesondere mit integrierten Schaltungsverstärkern, wie sie in Figur 4 skizziert sind, aber auch anderen optischen Faserempfängern. Jeder optische Faserempfänger ist dabei über eine elektrische Steckverbindung mit einer - nicht dargestellten - optischen Faser gekoppelt, zur Abbildung eines Lichtflecks aus der optischen Faser auf dem optischen Faserempfänger der Figur 3. Der Lichtfleck ist dabei in seiner Größe im Schnitt für die zwei Teildioden D1 und D2 ersichtlich.

Es versteht sich, dass der als Durchmesser angegebene Wert ein ungefährer Wert ist, der sich nicht zwingend auf eine Kreisform bezieht, was der Name suggeriert. Die entsprechende Abbildung zeigt in Figur 1 und Figur 2 eine mehreckige Gestaltung, die weitgehend an eine Kreisform angenähert ist, aber fertigungstechnische Gesichtspunkte für eine optimierte Fertigung in integrierter Form berücksichtigt.

Nach einer Verschaltung der Einzeldioden D1 bis D4 an ihren jeweiligen Transimpedanz-Verstärker 20 bis 23 ist die Anodenseite der Dioden an ein gemeinsames Potential geschaltet. Die Kathodenseite der Dioden liegt jeweils eigenständig an einem Eingang des elektrisch die Signale umsetzenden oder verstärkenden Transimpedanz-Verstärkers an, zur anschließenden elektrischen Zusammenführung in der Summenschaltung 30. Ausgehend von Figur 5 ist keine gut leitende elektrische Verbindung zwischen Anode und Kathode 1 bzw. Anode und Kathode 2 der zwei Fotodioden D1 bzw. D2 vorgesehen, so dass beide Anschlüsse nicht durch eine elektrisch leitfähige Verbindung miteinander gekoppelt sind, was sich nach einer Verschaltung in der Anordnung nach Figur 4 für nur jeweils einen Anschluß der Dioden ändert.

Die **Figur 6** zeigt die äquivalenten Eingangsrauschstromdichten folgender Systeme im Vergleich:
(a) Ganzflächige Fotodiode D mit einem Transimpedanzverstärker;
(b) Eine Teil-Fotodiode D1 mit einem Transimpedanzverstärker und
(c) Vier Teil-Fotodioden mit jeweils einem eigenen Transimpedanzverstärker und anschließender Addition im Summenverstärker 30.

Integriert man die Eingangsrauschstromdichten im Bereich 1MHz bis 150MHz, so erhält man folgende Werte für den äquivalenten Eingangsrauschstrom: Für die ganzflächige Fotodiode mit einem Transimpedanzverstärker 59,3nA, für die viergeteilte Fotodiode 11 mit vier Transimpedanzverstärkern und Summenverstärker: 33,5nA.

Durch die Vierteilung der Fotodiode kann die Bandbreite mehr als verdoppelt und der äquivalente Eingangsrauschstrom bei konstanter Bandbreite nahezu halbiert werden.

Die Bandbreite des Gesamtsystems von 402MHz ist ausreichend für die Verarbeitung einer Non-Retum-to-Zero (NRZ) Datenrate von 500Mbit/s bzw. von 622Mbit/s.

Für eine Fotodiode mit einem Durchmesser "d2" von 1 mm ergibt sich eine SperrschichtKapazität von 8,8pF. Eine von vier Teil-Fotodioden hat somit eine Sperrschichtkapazität von 2,2pF. Für die gleichgroße viergeteilte Fotodiode erreicht man mit dem Gesamtsystem bei einer Transimpedanz von 164kOhm eine Bandbreite von 116MHz, welche für eine Datenrate von 155Mbit/s ausreicht. Bei einer Verringerung der Rückkoppelwiderstände Rf in den Verstärkern 20 bis 23 ergibt sich bei einer Transimpedanz von 32,6kOhm eine Bandbreite von 413MHz (entsprechend einer Datenrate von 622Mbit/s).

Diese Datenraten können erstmals mit Hilfe des Fotodiodenprinzips zusammen mit einem effektiven Fotodiodendurchmesser von 1mm erreicht werden. Somit kann eine optoelektronische integrierte Schaltung (OEIC) für eine Plastikfaser mit 1mm Durchmesser eine Datenrate von über 500Mbit/s erreichen.

Eine weitere Anwendungsmöglichkeit liegt in optischen Empfängern für Glasfasern oder Plastikfasern, die eine hohe Justiertoleranz von optischen Steckverbindungen zulassen, bzw. keine Justierung erfordern.

### Bezugszeichenliste

Figur 1
   D : Diode
   d1: Durchmesser der Empfängerfläche
Figur 2
   D : Diode
   Rf: Rückkoppelwiderstand
Figur 3
   D1 : Teil-Diode
   D2 : Teil-Diode
   D3 : Teil-Diode
   D4 : Teil-Diode
   d2: Durchmesser der Gesamtdiode
   A-B: Schnittlinie siehe Figur5
Figur 4
   D1: Teil-Diode
   D2 : Teil-Diode
   D3 : Teil-Diode
   D4 : Teil-Diode
   Rf : Rückkoppelwiderstand
   R1 : Widerstand
   R2 : Widerstand

## Patentansprüche

1. Optischer Faserempfänger in einer optoelektronischen integrierten Schaltung (OEIC), mit zumindest einem Fotoempfänger (11) und zumindest einem Transimpedanzverstärker, wobei eine zugeordnete optische Plastikfaser relativ dick ist, und:
(i) der Fotoempfänger in mehrere Teil-Fotodioden (D1,D2,D3,D4) aufgeteilt ist, um aus mehreren Einzelfotodioden zu bestehen;
(ii) jede Teil-Fotodiode zu einem eigenen Transimpedanzverstärker (20,21,22,23) führt und die elektrischen Ausgangssignale der Transimpedanzverstärker in einem Summenverstärker (30) elektrisch zusammengefasst werden;
(iii) der zumindest eine Fotoempfänger, die Transimpedanzverstärker und zumindest ein Summenverstärker mit anderen Schaltungsteilen auf einem Chip monolithisch integriert sind, wobei der zumindest eine Fotoempfänger (11) eine Größenordnung bis im Wesentlichen 1mm Durchmesser (d2) hat.

2. Faserempfänger nach Anspruch 1, wobei vier Teilbereiche (D1,D2,D3,D4) des Fotoempfängers (11) als separate Fotodioden ausgebildet sind, insbesondere mit einer jeweils zwischenliegenden, optisch oder elektrisch unempfindlichen Zwischenzone (12).

3. Faserempfänger nach Anspruch 1 und 2, **dadurch gekennzeichnet, daß** dieser mit der CMOS-Technologie hergestellt ist.

4. Faserempfänger nach Anspruch 1 und 2, **dadurch gekennzeichnet, daß** dieser mit der Bipolar-Technologie hergestellt ist.

5. Faserempfänger nach Anspruch 1 und 2, **dadurch gekennzeichnet, daß** dieser mit der BICMOS-Technologie hergestellt ist.

6. Faserempfänger nach Anspruch 1, wobei die Transimpedanzverstärker als Operationsverstärker-Schaltungen aufgebaut sind.

7. Faserempfänger nach Anspruch 1 oder 6, wobei die Transimpedanzverstärker (21,22,23,20) als Strom-Spannungs-Wandler geschaltet sind.

8. **Verfahren** zum Aufnehmen eines hochfrequenten Lichtsignals in einem optischen Empfänger (11) am Ende einer über eine Steckverbindung angebrachten relativ dicken Plastikfaser, wobei der von der Faser auf den optischen Empfänger (11) abgebildete Lichtfleck auf mehrere Einzelbereiche (D1,D2,D3,D4) des aufgeteilten optischen Empfängers (11) fällt, welche Einzelbereiche elektrisch voneinander entkoppelt sind, die ausgangsseitig im Wesentlichen keine elektrische Leitfähigkeit zueinander besitzen, wobei der Lichtfleck eine Größenordnung von im Wesentlichen 1mm Durchmesser oder darunter aufweist, aber relativ großflächig ist, und die elektrischen Ausgangssignale elektrisch zusammen gefasst werden.

9. Verfahren nach Anspruch 8, wobei der abgebildete Lichtfleck im Wesentlichen an die Größe des optischen Empfängers (11) angepasst ist, oder vice versa.

10. Verfahren nach Anspruch 8, wobei jeder Einzelbereich (D1,D2,D3) des optischen Empfängers (11) kleiner als der Lichtfleck ist, bzw. kleiner als die Summenfläche des optischen Empfängers am Ende der Lichtleitfaser ausgebildet ist.

11. Verfahren nach Anspruch 8, wobei die von den Einzelbereichen abgegebenen elektrischen Signale über einen jeweils eigenständigen Verstärker (21,22,23,20) mit hoher Bandbreite geführt werden, und danach elektrisch zusammengefasst werden (30).

12. Verfahren nach Anspruch 8, wobei der optische Empfänger (11) ein optisches Signal aus derselben Faser im wesentlichen zeitgleich in mehrere korrespondierende elektrische Signale umsetzt, insbesondere über die mehreren eigenständigen Fotodioden als Einielbereiche (D1 bis D4) zur Bildung des optischen Empfängers.

## Claims

1. Optical fibre receiver in an optoelectronic integrated circuit (OEIC), having at least one photoreceiver (11) and at least one transimpedance amplifier, wherein an assigned optical plastic fibre is relatively thick, and:
(i) the photoreceiver is divided into several part photodiodes (D1, D2, D3, D4) in order to consist of several individual photodiodes;
(ii) each part photodiode leads to a separate transimpedance amplifier (20, 21, 22, 23) and the electrical output signals of the transimpedance amplifier are combined electrically in a master amplifier (30);
(iii) the at least one photoreceiver, the transimpedance amplifier and at least one master amplifier are integrated monolithically with other circuit parts on a chip, wherein the at least one photoreceiver (11) has an order of magnitude up to essentially 1 mm diameter (d2).

2. Fibre receiver according to claim 1, wherein four part regions (D1, D2, D3, D4) of the photoreceiver (11) are formed as separate photodiodes, in particular having in each case an intermediate, optically or electrically non-sensitive intermediate zone (12).

3. Fibre receiver according to claim 1 and 2, **characterised in that** the latter is produced using CMOS technology.

4. Fibre receiver according to claim 1 and 2, **characterised in that** the latter is produced using bipolar technology.

5. Fibre receiver according to claim 1 and 2, **characterised in that** the latter is produced using BICMOS technology.

6. Fibre receiver according to claim 1, wherein the transimpedance amplifiers are constructed as operational amplifier circuits.

7. Fibre receiver according to claim 1 or 6, wherein the transimpedance amplifiers (21, 22, 23, 20) are connected as current-to-voltage converters.

8. Process for receiving a high-frequency light signal in an optical receiver (11) at the end of a relatively thick plastic fibre attached via a plug-in connection, wherein the light spot formed by the fibre on the optical receiver (11) falls on several individual regions (D1, D2, D3, D4) of the divided optical receiver (11), which individual regions are electrically uncoupled from one another, which have on the output side essentially no electrical conductivity with respect to one another, wherein the light spot has an order of magnitude of essentially 1 mm diameter or below, but has a relatively large surface area, and the electrical output signals are combined electrically.

9. Process according to claim 8, wherein the light spot formed is adapted essentially to the size of the optical receiver (11), or vice versa.

10. Process according to claim 8, wherein each individual region (D1, D2, D3) of the optical receiver (11) is smaller than the light spot, or is designed to be smaller than the cumulative surface of the optical receiver at the end of the optical fibre.

11. Process according to claim 8, wherein the electrical signals emitted by the individual regions are guided via an in each case independent amplifier (21, 22, 23, 20) with high bandwidth, and are then electrically combined (30).

12. Process according to claim 8, wherein the optical receiver (11) converts an optical signal from the same fibre essentially at the same time into several corresponding electrical signals, in particular via the several independent photodiodes as individual regions (D1 to D4) to form the optical receiver.

## Revendications

1. Récepteur à fibres optiques dans un circuit intégré optoélectronique (OEIC), avec au moins un photorécepteur (11) et avec au moins un amplificateur de transimpédance, dans lequel une fibre optique plastique associée est relativement épaisse, et :
(i) le photorécepteur est divisé en plusieurs photodiodes partielles (D1, D2, D3, D4) pour être constitué de plusieurs photodiodes individuelles ;
(ii) chaque photodiode partielle conduit à un amplificateur de transimpédance particulier (20, 21, 22, 23) et les signaux de sortie électriques des amplificateurs de transimpédance sont réunis électriquement dans un amplificateur totalisateur (30) ;
(iii) le ou les photorécepteurs, les amplificateurs de transimpédance et au moins un amplificateur totalisateur sont intégrés de façon monolithique avec d'autres parties de circuit sur une puce, le ou les photorécepteurs (11) ayant un diamètre (d2) de l'ordre de 1 mm environ au maximum.

2. Récepteur à fibres selon la revendication 1, dans lequel quatre zones partielles (D1, D2, D3, D4) du photorécepteur (11) sont conçues comme des photodiodes séparées, notamment avec une zone intermédiaire (12) placée à chaque fois entre elles et insensible d'un point de vue optique ou électrique.

3. Récepteur à fibres selon les revendications 1 et 2, **caractérisé en ce qu'**il est fabriqué selon la technologie CMOS.

4. Récepteur à fibres selon les revendications 1 et 2, **caractérisé en ce qu'**il est fabriqué selon la technologie bipolaire.

5. Récepteur à fibres selon les revendications 1 et 2, **caractérisé en ce qu'**il est fabriqué selon la technologie BICMOS.

6. Récepteur à fibres selon la revendication 1, dans lequel les amplificateurs de transimpédance sont construits comme des circuits à amplificateurs opérationnels.

7. Récepteur à fibres selon la revendication 1 ou 6, dans lequel les amplificateurs de transimpédance (21, 22, 23, 20) sont branchés comme des convertisseurs courant-tension.

8. Procédé pour la réception d'un signal lumineux à haute fréquence dans un récepteur optique (11) à l'extrémité d'une fibre plastique relativement épaisse montée par l'intermédiaire d'une liaison enfichable, la tache de lumière projetée par la fibre sur le récepteur optique (11) arrivant sur plusieurs zones individuelles (D1, D2, D3, D4) du récepteur optique divisé (11), lesquelles zones individuelles sont découplées électriquement les unes des autres et n'ont globalement en sortie aucune conductibilité électrique les unes avec les autres, la tache de lumière ayant un diamètre de l'ordre de 1 mm environ ou moins mais ayant une relativement grande surface et les signaux de sortie électriques étant réunis électriquement.

9. Procédé selon la revendication 8, dans lequel la tache de lumière projetée est globalement adaptée à la dimension du récepteur optique (11), ou vice-versa.

10. Procédé selon la revendication 8, dans lequel chaque zone individuelle (D1, D2, D3) du récepteur optique (11) est conçue plus petite que la tache de lumière respectivement plus petite que la surface totale du récepteur optique à l'extrémité de la fibre guide d'ondes lumineuses.

11. Procédé selon la revendication 8, dans lequel les signaux électriques fournis par les zones individuelles passent par un amplificateur (21, 22, 23, 20) à chaque fois indépendant et à grande largeur de bande et sont ensuite réunis électriquement (30).

12. Procédé selon la revendication 8, dans lequel le récepteur optique (11) convertit de manière globalement isochrone un signal optique provenant de la même fibre en plusieurs signaux électriques correspondants, notamment par l'intermédiaire des photodiodes indépendantes comme zones individuelles (D1 à D4) destinées à la formation du récepteur optique.
